Europäisches Patentamt

European Patent Office

Office européen des brevets

(11) Veröffentlichungsnummer: **0 426 894 A1**

# EUROPÄISCHE PATENTANMELDUNG

(21) Anmeldenummer: 89120718.5

(22) Anmeldetag: 08.11.89

(51) Int. Cl.5: **H04J 3/06, H04L 7/10**

(43) Veröffentlichungstag der Anmeldung:
**15.05.91 Patentblatt 91/20**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**W-8000 München 2(DE)**

(72) Erfinder: **Friederichs, Karl-Josef, Dr.-Ing.**
**Blütenstrasse 65a**
**W-8039 Puchheim(DE)**
Erfinder: **Rockenbach, Günter, Dipl.-Ing. (FH)**
**Wintrichring 105**
**W-8000 München 50(DE)**

(54) Verfahren zur schnellen Empfängersynchronisation unter Ausnutzung einer fehlerkorrigierenden Codierung.

(57) Es wird ein Verfahren zur schnellen Rahmensynchronisation auf der Empfangsseite digitaler Übertragungssysteme vorgeschlagen, das eine schnelle Synchronisation auch bei hohen Bitfehlerraten ermöglicht. Dafür ist vorgesehen, daß die Datensignale am Ausgang eines für zwei Betriebsarten ausgelegten FEC-Decoders (1) abgegriffen und einer den FEC-Decoder (1) synchronisierenden Schaltung (2) zugeführt werden. In der ersten Betriebsart ist die Korrekturfähigkeit des FEC-Decoders (1) abgeschaltet; die Daten werden transparent durchgeschaltet bis zur Detektierung mindestens eines Teiles eines Rahmenkennwortes und Erzielung einer vorfläufigen Anfangssynchronisation. Dann wird die Korrekturfähigkeit des FEC-Decoders (1) eingeschaltet und der Rest des Synchronisationsvorganges durch FEC unterstützt.

FIG 2

EP 0 426 894 A1

## VERFAHREN ZUR SCHNELLEN EMPFÄNGERSYNCHRONISATION UNTER AUSNUTZUNG EINER FEHLER-KORRIGIERENDEN CODIERUNG.

Die Erfindung bezieht sich auf ein Verfahren zur schnellen Rahmensynchronisation digitaler Übertragungssysteme mit fehlerkorrigierender Codierung (FEC = Forward Error Correction).

In modernen digitalen Übertragungssystemen werden die zu übertragenden Daten in der Regel in eine Rahmenstruktur eingebunden. Sinn und Zweck eines solchen Rahmens ist es, eine parallele Übertragung mehrerer unabhängiger Datenströme oder auch systemspezifischer Daten in einem Übertragungsweg zu ermöglichen. Hierbei muß der Empfänger auf den Rahmen synchronisieren, um eine Trennung der systemspezifischen Daten bzw. der unterschiedlichen Datenströme zu erzielen. Die Empfängersynchronisation kann durch externe Störungen und dadurch bedingte Bitfehler erheblich beeinträchtigt werden.

Zur Verbesserung der Übertragungsqualität von digitalen Übertragungssystemen wird in jüngerer Zeit häufig eine fehlerkorrigierende Codierung (FEC) eingesetzt. Mit dieser soll einerseits eine durch Systemimperfektionen bedingte Grundfehlerrate beseitigt werden, andererseits soll aber auch bei geringem Signalrauschverhältnis (S/N) ein deutlicher Codegewinn erzielt werden. Beispielsweise ist es mit einer leistungsfähigen FEC durchaus möglich, eine relativ hohe empfangsseitige Bitfehlerrate von $BER = 10^{-2}$ auf $BER < 10^{-3}$ zu verbessern. Auch für die Funktion der FEC ist eine Synchronisation des empfängerseitigen Decoders auf die empfangene Codesequenz erforderlich. Insgesamt kommt der Empfängersynchronisation in der digitalen Übertragungstechnik eine erhebliche Bedeutung zu.

In bisherigen digitalen Übertragungssystemen, wie sie beispielsweise aus "Error-Correction Coding for Digital Communications" von G.C. Clark, Jr. and J.B. Cain, erschienen im Plenum Press, New York 1982, bekannt sind, wird zur Rahmensynchroni sation in jeden Rahmen eine im Empfänger bekannte feste Bitfolge, das sog. Rahmenkennwort eingefügt. Dieses Rahmenkennwort wird im Empfänger mittels einer geeigneten Schaltung detektiert. Um einer Fehlsynchronisation durch zufällige Vortäuschung eines falschen Rahmenkennwortes vorzubeugen und um auch beim Auftreten von Bitfehlern eine hinreichend zuverlässige Synchronisation zu erreichen, verläßt man sich allerdings nicht auf die Detektion eines einzigen Rahmenkennwortes. Vielmehr wartet man noch ab und überprüft, ob in den richtigen zeitlichen Abständen weitere Rahmenkennwörter auftreten. Der Synchronismus wird erst dann deklariert, wenn innerhalb von n möglichen Rahmenkennwörtern m richtig erkannt worden sind (m aus n Strategie). Mögliche Synchronisationsstrategien sind z. B. 5 aus 6 oder 5 aus 5.

Beim Einsatz einer FEC gibt es mehrere Möglichkeiten zur Synchronisation derselben. Eine Möglichkeit besteht darin, den Codesynchronismus so lange zu suchen, bis der FEC-Decoder gültige Codesequenzen findet. Dies ist in der vorstehend genannten Literaturstelle näher beschrieben. Eine weitere Möglichkeit besteht darin, den fehlerkorrigierenden Code fest an die Rahmenstruktur zu koppeln. Im Empfänger muß dann zunächst die Rahmensynchronisation gemäß der oben beschriebenen Strategie durchgeführt werden. Anschließend kann der FEC-Decoder auf den Rahmen und damit auch auf die empfangene Codesequenz synchronisieren. Nachteilig bei den beiden genannten Verfahren ist, daß sich bei hohen Bitfehlerraten am Empfängereingang (z. B. $BER = 10^{-2}$) große Synchronisationszeiten ergeben.

Der Erfindung liegt die Aufgabe zugrunde, ein Verfahren anzugeben, das auch bei hohen Bitfehlerraten noch eine schnelle Empfängersynchronisation ermöglicht.

Diese Aufgabe wird gemäß der Erfindung in der Weise gelöst, daß die Datensignale am Ausgang eines für zwei Betriebsarten ausgelegten FEC-Decoders abgegriffen und einer Synchronisationsschaltung zugeführt werden, die den FEC-Decoder synchronisiert, daß in der ersten Betriebsart die Korrekturfähigkeit des FEC-Decoders abgeschaltet ist und die Daten transparent durchgeschaltet werden bis zur Detektierung mindestens eines Teiles eines Rahmenwortes und Erzielung einer vorläufigen Anfangssynchronisation und daß dann die Korrekturfähigkeit des FEC-Decoders als dessen zweite Betriebsart eingeschaltet und der Rest des Synchronisationsvorganges durch die Vorwärtsfehlerkorrektur unterstützt wird.

Mit dem erfindungsgemäßen Verfahren wird auch bei hohen Bitfehlerraten noch eine schnelle Synchronisation von Rahmen und FEC-Decoder erreicht. Die Funktion des Verfahrens beruht auf einer Einbindung des fehlerkorrigierenden Codes in die Rahmenstruktur und einer Ausnutzung der Leistungsfähigkeit der FEC zur Rahmensynchronisation.

Die Betriebsartenumschaltung des FEC-Decoders erfolgt in vorteilhafter Weise über die Synchronisationsschaltung.

Nachstehend wird die Erfindung anhand eines in der Zeichnung dargestellten Ausführungsbeispiels näher erläutert.

Es zeigen:

Fig. 1 eine Rahmenstruktur und

Fig. 2 die Anordnung von FEC-Decoder und Synchronisationsschaltung im Blockschaltbild.

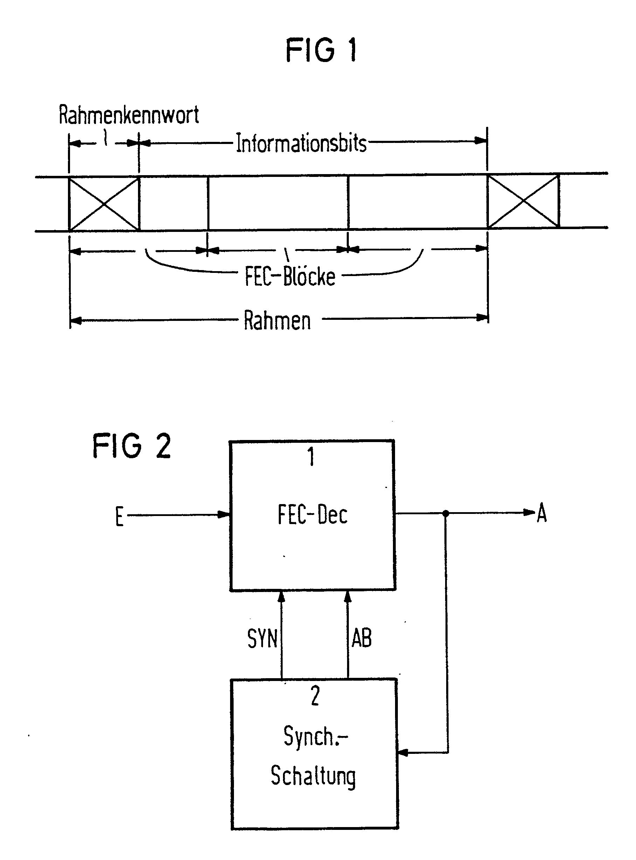

In Figur 1 ist die prinzipielle Rahmenstruktur dargestellt. Hiernach besteht ein Rahmen aus einem Rahmenkennwort und den zu übertragenden Informationsbits. Ferner ist jeder Rahmen in einen oder mehrere FEC-Blöcke unterteilt, wobei sowohl die Daten als auch das Rahmenkennwort von der FEC erfaßt werden.

Figur 2 zeigt eine Ausführungsform von FEC-Decoder 1 und Synchronisationsschaltung 2 zur Durchführung des Synchronisationsverfahrens. Hiernach werden die empfangenen Datensignale am Schaltungseingang E zunächst dem Decoder 1 zugeführt. Der Decoder hat zwei mögliche Betriebsarten A und B. In der Betriebs art A ist die Korrekturfähigkeit des Decoders abgeschaltet. In diesem Fall reicht der Decoder 1 die Datensignale transparent vom Eingang E zum Ausgang A durch. In der Betriebsart B ist die Korrekturfähigkeit des Decoders eingeschaltet, so daß empfangene Bitfehler korrigiert werden können. Am Ausgang des Decoders 1 werden die Datensignale abgegriffen und zur Synchronisationsschaltung 2 zurückgeführt. Von der Synchronisationsschaltung 2 führen die zwei Steuersignale SYN und AB zum Decoder 1.

Ein Synchronisationsvorgang läuft nun folgendermaßen ab: Zunächst befindet sich der Decoder 1 in der Betriebsart A, so daß die empfangenen Datensignale transparent durchgeschaltet werden. Die Synchronisationsschaltung 2 sucht nun die Datensignale nach einem Rahmenkennwort ab. Wenn sie ein mögliches detektiert hat, wird der mutmaßliche Anfang des Rahmens und damit auch das Raster der FEC-Blöcke über die Steuerleitung SYN an den Decoder 1 mitgeteilt. Gleichzeitig wird der Decoder 1 über die Steuerleitung AB in die Betriebsart 8 umgeschaltet, so daß die folgenden Datensignale auf Bitfehler überprüft und korrigiert werden. Der Synchronisationsvorgang läuft dann in der vorstehend beschriebenen Weise weiter ab, bis das gewünschte Synchronisationskriterium erfüllt ist und damit der Synchronismus deklariert werden kann.

Der Vorteil des Verfahrens macht sich hauptsächlich bei hohen Bitfehlerraten am Empfängereingang bemerkbar. Er besteht darin, daß in den Synchronisationsvorgang nur ein Rahmenkennwort mit der hohen eingangsseitigen Bitfehlerrate einfließt, während die nachfolgenden Rahmenkennwörter mit Hilfe der FEC in ihrer Bitfehlerrate reduziert werden. Hierdurch verringert sich die Wahrscheinlichkeit, daß ein Synchronisationsvorgang fälschlicherweise aufgrund von Bitfehlern abgebrochen und neu gestartet wird. Insgesamt ergeben sich dadurch hauptsächlich bei hohen eingangsseitigen Bitfehlerraten (z. B. BER = $10^{-2}$) deutlich kürzere mittlere Synchronisationszeiten. Weiterhin bleibt in einem bereits synchronisierten Empfänger bei plötzlich ansteigender Bitfehlerrate der Synchronismus länger erhalten, da die Synchronisationsschaltung mit Daten versorgt sind, welche hinter der FEC-Decodierung abgegriffen werden.

Das erfindungsgemäße Verfahren wirkt sich nicht negativ auf das Synchronisationsverhalten aus, wenn das erste detektierte Rahmenkennwort kein echtes, sondern ein zufällig vorgetäuschtes ist. In diesem Fall wird der Decoder zwar in einem falschen FEC-Raster gestartet und beginnt mutmaßliche Bitfehler wild zu korrigieren. Dies erhöht jedoch nicht die Wahrscheinlichkeit, mit der im Rahmenabstand weitere falsche Rahmenkennwörter vorgetäuscht werden. Sobald ein derartiger falscher Synchronisationsvorgang erkannt wird, kann der gesamte Synchronisationsvorgang neu gestartet werden.

Das erfindungsgemäße Verfahren ist auch nicht unbedingt darauf angewiesen, daß die in Figur 1 dargestellte Rahmenstruktur verwendet wird. Insbesondere muß ein Rahmenkennwort nicht als geschlossener Block am Anfang eines Rahmens stehen, sondern kann in beliebiger Weise über den Rahmen verteilt sein. Ferner muß die Korrekturfähigkeit des Decoders beim Synchronisationsvorgang nicht genau nach der Detektion des ersten Rahmenkennwortes eingeschaltet werden. Wichtig ist nur, daß bei abgeschaltetem Decoder zunächst eine gewisse Anfangssynchronisation erzielt und der Decoder dann zugeschaltet wird. Dies kann je nach den gewünschten Synchronisationseigenschaften auch bereits geschehen, wenn ein Teil des ersten Rahmenkennwortes detektiert wurde oder erst zu einem späteren Zeitpunkt, wenn innerhalb des Synchronisationsvorganges mehr als ein Rahmenkennwort detektiert wurde.

Ferner soll noch erwähnt werden, daß das erfindungsgemäße Verfahren prinzipiell von der Art der verwendeten Codierung unabhängig ist. Es können sowohl Blockcodes als auch Faltungscodes eingesetzt werden, wobei lediglich eine feste Anbindung des Codes an die Rahmenstruktur gewährleistet sein muß.

**Ansprüche**

1. Verfahren zur schnellen Rahmensynchronisation auf der Empfangsseite digitaler Übertragungssysteme mit fehlerkorrigierender Codierung (FEC = Forward Error Correction), **dadurch gekennzeichnet,** daß die Datensignale am Ausgang eines für zwei Betriebsarten ausgelegten FEC-Decoders abgegriffen und einer Synchronisationsschaltung zugeführt werden, die den FEC-Decoder synchronisiert, daß in der ersten Betriebsart die Korrekturfähigkeit des FEC-Decoders abgeschaltet ist und die Daten transparent durchgeschaltet werden bis zur Detektierung mindestens eines Teiles eines Rahmenkennwortes und Erzielung einer vorläufigen Anfangssynchronisation und daß dann die Korrekturfähigkeit des FEC-Decoders als dessen zweite Betriebsart eingeschaltet und der Rest des Synchronisationsvorganges durch die Vorwärtsfehlerkorrektur unterstützt wird.

2. Verfahren nach Anspruch 1, **dadurch gekennzeichnet,** daß die Betriebsartenumschaltung des FEC-Decoders über die Synchronisationsschaltung erfolgt.

# FIG 1

Rahmenkennwort

Informationsbits

FEC-Blöcke

Rahmen

# FIG 2

E → | 1 FEC-Dec | → A

SYN    AB

| 2 Synch.- Schaltung |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-3 837 920 (GARRETT APPLE et al.) * Spalte 2, Zeilen 25-38; Spalte 7, Zeilen 18-50; Spalte 9, Zeile 14 - Spalte 10, Zeile 52; Spalte 10, Zeilen 35-68 * ----- | 1,2 | H 04 J 3/06 H 04 L 7/10 |

RECHERCHIERTE SACHGEBIETE (Int. Cl.5)

H 04 J
H 04 L

Der vorliegende Recherchenbericht wurde für alle Patentansprüche erstellt

| Recherchenort | Abschlußdatum der Recherche | Prüfer |
|---|---|---|
| DEN HAAG | 12-07-1990 | VAN DEN BERG, J.G.J. |

EPO FORM 1503 03.82 (P0403)